# EUROPEAN PATENT SPECIFICATION

(11) **EP 1 233 273 B1**
(45) Date of publication and mention of the grant of the patent: **04.10.2006**
(21) Application number: 02002685.2
(22) Date of filing: 06.02.2002
(51) Int. Cl.: G01R 29/08

(54) **Device for monitoring electromagnetic fields**
Vorrichtung zur Überwachung eines elektromagnetischen Feldes
Dispositif de surveillance d'un champ électromagnétique

(30) Priority: 20.02.2001 IT TO010152
(43) Date of publication of application: 21.08.2002
(73) Proprietor: Telecom Italia S.p.A., 20123 Milano (IT)
(72) Inventor: Gigliotti, Vincenzo, 10148 Torino (IT); Squizzato, Valter, 10148 Torino (IT)
(74) Representative: Giannesi, Pier Giovanni

(56) References cited:
- DE-A- 19 722 350
- US-A- 5 295 072
- PATENT ABSTRACTS OF JAPAN vol. 1996, no. 06, 28 June 1996 (1996-06-28) -& JP 08 043465 A (SONY TEKTRONIX CORP), 16 February 1996 (1996-02-16)
- PATENT ABSTRACTS OF JAPAN vol. 1998, no. 13, 30 November 1998 (1998-11-30) -& JP 10 227819 A (KITAGAWA IND CO LTD), 25 August 1998 (1998-08-25)

## Description

### Technical Field

The present invention relates to devices for monitoring electromagnetic fields and was developed with particular attention to potential application in monitoring the level, or in other words the strength, of ambient electromagnetic fields.

### Background Art

A known method of performing such a monitoring function is to use measuring instruments which are carried by an operator to the site where the strength of an electromagnetic field is to be determined. Often, after a first rough measurement of approximate E-field strength made using a small portable instrument, it is necessary to proceed with more accurate measurements using more sophisticated instruments.

Attempts have also been made to perform monitoring using fixed stations capable of continuously measuring changes in electromagnetic field strength at the point where the station is installed.

In addition, DE 197 22 350A discloses a meter producing output signals which are fed to an installation control circuit, e.g. a stored program controller or a process controller. The output signals are provided as an input signal for the individual units to be monitored for their electromagnetic radiation. The installation control circuit compares these output signals with values set in its program and executes program-dependent operations from the result. The allocation of the data-set in the program for the comparison depends on the instantaneous output signal of the installation control circuit. The values to be compared are fixed values set by the program or, during a process cycle which has been initiated, the instantaneous output signals of the radio interference meter acquired by the installation control circuit and processed as comparison values

Further, US 5,295,072 discloses a sampled data lightning strike detection and mapping system comprising: means for sampling a received signal waveform representative of a lightning strike to generate a train of data samples representative of the received waveform; means for identifying a data sample of the train which exceeds a predetermined threshold level as a trigger sample; means for recovering a predetermined number of data samples, preceeding the trigger sample; and means for processing the recovered predetermined number of data samples to detect and map the lightning strike.

In view of the mounting concerns about exposure to electromagnetic fields, it is imperative to develop monitoring solutions which have been perfected in a variety of respects, including:
- The ability to perform selective monitoring for different frequency ranges or bandwidths, and thus distinguish and identify the various sources in relation to their contributions to overall electromagnetic field strength,
- The ability to perform monitoring whose purpose is to determine when predetermined E-field strength thresholds are reached, rather than to measure the field and its strength on a continuous basis,
- The ability to implement a remote monitoring function, thus avoiding the need to access the site where the monitoring station is installed, with the further ability to selectively and remotely vary monitoring parameters such as the threshold levels taken into consideration, and
- The ability, which is closely linked to the capabilities cited in the previous paragraph, to use measurement and monitoring points which can be freely and readily located in widely dissimilar positions in order to set up a geographically distributed monitoring network.

### Disclosure of the Invention

The object of the present invention is thus to provide a solution capable of satisfying all of the needs indicated above. In accordance with the present invention, this object is achieved by means of a device having the characteristics detailed in the following claims.

### Brief Description of Drawings

The following description of the invention, which is intended purely by way of example and is not to be construed as limiting, will make reference to the accompanying drawings, where:
- Figure **1** provides a general illustration of the context in which a device in accordance with the invention is used, and
- Figure **2** is a block diagram illustrating the circuitry of a device in accordance with the invention.

### Best mode for Carrying Out the Invention

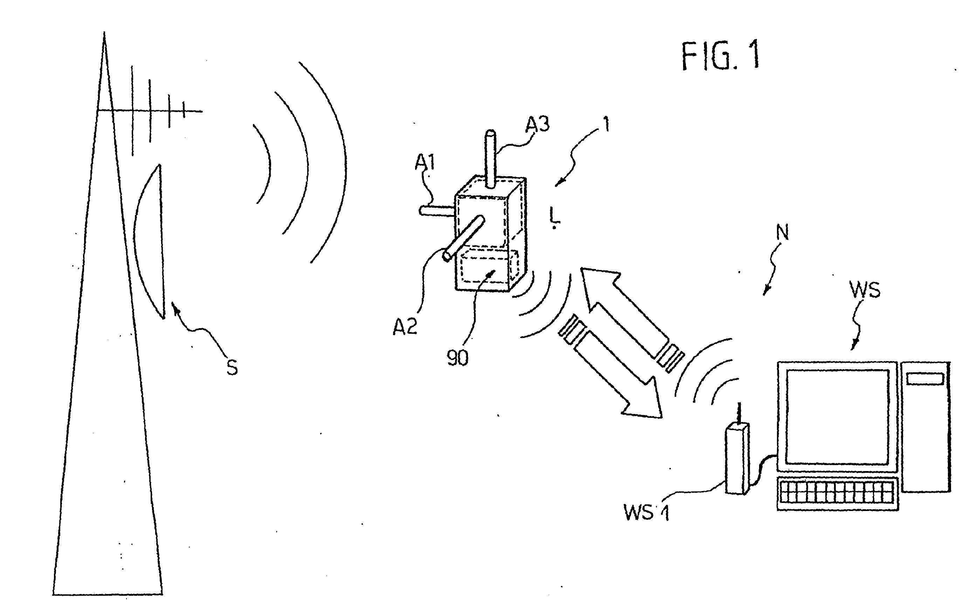

As illustrated in Figure 1, a monitoring device in accordance with the invention and designated in the figure by the number 1 is intended to measure the electromagnetic field at a site designated generically by the letter L.

In general, the electromagnetic field derives from the overlapping electromagnetic fields produced by a more or less large number of sources, one of which is illustrated schematically and designated by the letter S.

For purposes of illustration, the sources in question may be said to consist, for example, of:
- Radio and/or television transmitters (which, at least in urban areas with large concentrations of broadcasters, are the most significant source of detectable ambient electromagnetic fields),
- Telecommunications system transmitters, e.g., for mobile telephony,
- Miscellaneous sources such as remote-control units, dedicated generators of electromagnetic waves of various kinds, etc.

An important characteristic of the device 1 in accordance with the invention is that it makes it possible to perform a remote monitoring function, or in other words without requiring that an operator be present at the site L where the device 1 is installed.

As will become apparent below, in fact, the device 1 is capable of interfacing in a telecommunications network N (e.g., a mobile telephony network) in order to transmit and/or receive data to and from a remote station WS which can be manned or in any case periodically supervised by an operator.

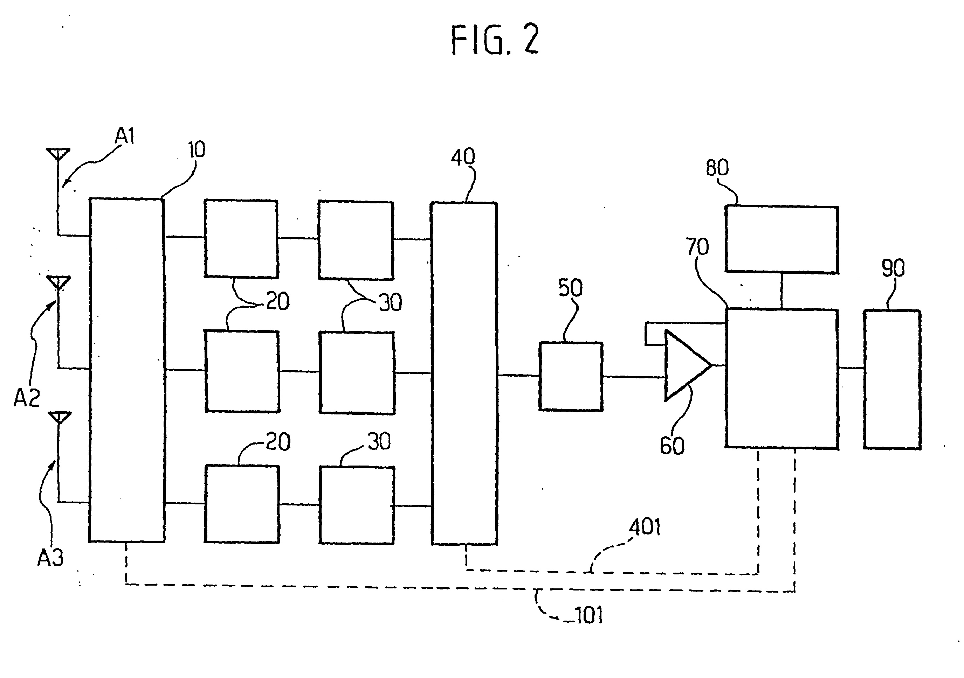

Turning now to a more detailed analysis of the diagram shown in Figure 2, references A1, A2 and A3 designate three antennas (implemented using any known technology, e.g., in the form of whip, dipole or loop antennas) oriented with their respective directions of maximum sensitivity lying in different directions, and typically along three directions corresponding to the X, Y and Z axes of an orthogonal or Cartesian coordinate system (see Figure 1).

This arrangement is such that the electric and/or magnetic components of the ambient electromagnetic field can be sensed independently of whether electromagnetic fields whose polarization is predominately in a single direction are present, this being a situation that can, for example, occur near transmitters which emit an electromagnetic wave with a predetermined vertical or horizontal polarization plane.

Reference 10 designates a band selector device designed to act in accordance with the prior art on antennas A1, A2 and A3 and/or on the reception chain associated with them in such a way as to make device 1 exclusively (or at least prevalently) sensitive to the electromagnetic field in at least two frequency ranges or bands, for example the UHF band for monitoring the electromagnetic field associated with emissions from terrestrial radio and television transmitters, the band used by GSM systems for monitoring the signal strength deriving from coverage of site L on the part of one or more mobile telephony networks, etc..

The selector unit 10 (which in practice selects the band in which monitoring is to be performed) operates in response to a command signal received over a line 101 from a control unit which will be described in further detail below.

The band selector unit 10 is provided with a set of cascaded filter units 20 which operate separately on the signals from each of the antennas A1, A2 and A3 and are intended to increase the accuracy and selectivity with which the electromagnetic field is measured in the band taken into consideration.

References 30 designate radio-frequency rectifier units, which like filters 20 are implemented in accordance with the prior art. Each of the rectifier units 30 receives the output signal from the filter 20 located immediately upstream and, at its own output, generates a rectified signal corresponding in practice to the envelope of the radio-frequency signal provided at its input.

At its output, each rectifier 30 thus provides a signal which is indicative of the electromagnetic field strength measured in the main direction of sensitivity of the associated antenna A1, A2 and A3 in the frequency range or band selected on each occasion by means of band selector 10.

The field strength signals generated by rectifiers 30 are sent to a multiplexer unit 40 whose function is to permit the various field strength signals to be processed using a time division scheme. This takes place under the control of a command signal supplied over a line 401 from the control unit mentioned above.

As will be readily apparent to a person skilled in the art, each of the aforesaid field strength signals can, at least in principle, be analyzed and handled independently by separate processing and handling setups.

The fact that a time division multiplexing scheme is used makes it possible to employ a single analysis setup to handle the various field strength signals, thus reducing the complexity of the device's circuitry.

Reference 50 designates an analog-to-digital converter whereby the various output signals from rectifiers 30 are converted into digital form for subsequent processing.

This processing essentially involves comparing the various field strength signals with one or more threshold levels applied to a threshold comparator 60.

Preferably, this threshold level or levels will be established by the control unit mentioned above. This unit, designated by the number 70 in the diagram shown in Figure 2, preferably consists of a microcontroller or similar processing device carrying an associated memory block 80. The latter usually comprises, in accordance with a well-known solution, a ROM memory for storing configuration and program instructions, and a RAM memory for storing the input/output data from device 1.

Finally, reference 90 designates a communication module configured, for example, in the form of a modem such as a GSM modem operating with an RS232 serial interface so that data can be transmitted between the device 1 and the remote station WS, which is equipped for this purpose with a modem WS1.

In this way, a bidirectional connection can be established between the device 1 and the station WS whereby the device 1 can transmit, for example, data corresponding to the measurements made and any alarm signals (field strength beyond the thresholds, etc.) to the station WS. Symmetrically, the station WS can transmit requests to perform measurements, band selection data, measurement threshold data and so forth to the device 1.

The structure as described provides a high degree of flexibility in performing monitoring activities.

In particular, the control unit 70 is capable of operating (e.g., in response to instructions received from the station WS) in such a way as to selectively vary:
- The band selected by the selector 10, and hence the frequency range in which monitoring is performed, and
- The threshold level applied in device 60.

In this way, monitoring can be performed with specific reference to different and clearly identified sources of electromagnetic fields.

Likewise, the threshold level or levels with which the element 60 operates is (are) capable of being changed, for example in order to take different needs into account (e.g., where different signal levels are to be monitored for different frequency ranges or bands, and thus for different sources).

Additionally, the device 1 lends itself readily to being implemented in such a way that it can be maintained in standby status (with minimum power consumption) and then activated by means of a command transmitted by the station WS, so that monitoring can be carried out at predetermined times, e.g., in accordance with a polling scheme applied to a number of devices 1 in different locations.

The fact that the device 1 can be implemented as a mobile device (e.g., as part of a network N which is a mobile radio network) and/or as a low power consumption device makes it possible to use the device 1 as a flexible measurement instrument capable of being readily located in widely dissimilar sites L (and if necessary at successive times) without having to provide special power supply units and/or communication terminals at the site, thus facilitating the deployment of geographically distributed monitoring networks.

Naturally, and without detriment to the invention's underlying principle, details and forms of implementation may vary widely with respect to the descriptions and illustrations provided herein, provided that they fall within the scope of the present invention as defined in the claims.

## Claims

1. A device for monitoring electromagnetic fields, comprising:
- at least one antenna element (A1, A2, A3) for electromagnetic field measurements,
- a reception chain (10, 20, 30) capable of generating at least one signal which is indicative of the electromagnetic field strength measured by said at least one antenna element (A1, A2, A3),
- a threshold comparator element (60) for comparing said at least one field strength signal generated by said reception chain (20, 30, 40) with at least one associated threshold level,
said device also exhibiting at least one of the following characteristics:
- a selector element (10) provided to make the device (1) selectively sensitive to at least two electromagnetic field frequency bands,
- said at least one threshold level of said threshold comparator element (60) being selectively variable,
said device being **characterized in that** it further comprises:
- a communication interface (90) provided so that signals can be transmitted to the device (10), and
- at least one control unit (70) configured so as to selectively vary at least one monitoring parameter selected in the group consisting of:
- the frequency band selected by said selector element (10),
- said one or more threshold levels of said threshold comparator element (60);
said device being further **characterized in that** said at least one control unit (70) is configured to selectively vary said at least one monitoring parameter in response to the signals received from said communication interface (90).

2. A device in accordance with claim 1, **characterized in that** it comprises a plurality of antenna elements (A1, A2, A3) whose sensitivity is oriented in different directions.

3. A device in accordance with claim 2, **characterized in that** it comprises at least three antenna elements (A1, A2, A3) whose respective directions of sensitivity are oriented along a set of three mutually orthogonal axes (X, Y, Z).

4. A device in accordance with claim 2, **characterized in that** the antenna elements in said plurality (A1, A2, A3) are each associated with separate reception chains (20, 30), the device also comprising a multiplexer element (40) for handling the signals generated by said separate reception chains (20, 30) using a general time division multiplexing scheme.

5. A device in accordance with any of the foregoing claims, **characterized in that** said communication interface is configured as an interface for communication with a mobile communication interface.

6. A device in accordance with claim 1 or with claim 5, **characterized in that** said communication interface (90) operates as a serial interface, preferably according to the RS232 standard.

7. A distributed electromagnetic field monitoring network comprising a plurality of devices according to at least one of claims 1-6.

## Patentansprüche

1. Vorrichtung zum Überwachen'elektromagnetischer Felder, umfassend:
- zumindest ein Antennenelement (A1, A2, A3) für Messungen des elektromagnetischen Feldes;
- eine Empfangskette (10, 20, 30), die eingerichtet ist, zumindest ein Signal zu erzeugen, welches die Stärke des elektromagnetischen Feldes angibt, welches von dem zumindest einen Antennenelement (A1, A2, A3) gemessen wurde;
- ein Schwellwert-Vergleichselement (60) zum Vergleichen der zumindest einen Feld-Signalstärke, die von der Empfangskette (20, 30, 40) erzeugt wurde, mit zumindest einem zugeordneten Schwellwertpegel,
wobei die Vorrichtung ferner mindestens eines der folgenden Merkmale aufweist:
- ein Auswahlelement (10), das vorgesehen ist, um die Vorrichtung (1) selektiv empfindlich gegenüber mindestens zwei Frequenzbändern des elektromagnetischen Feldes vorzusehen;
- zumindest einer der Schwellwertpegel des Schwellwert-Vergleicherelements (60) ist auswählbar variabel;
wobei die Vorrichtung ferner umfaßt:
- eine Kommunikationsschnittstelle (90), die derart eingerichtet ist, daß Signale zu der Vorrichtung (10) übertragen werden können, und
- zumindest eine Steuereinheit (70), die eingerichtet ist, zumindest einen Überwachungsparameter selektiv zu ändern, wobei der zumindest eine Überwachungsparameter ausgewählt ist aus der Gruppe:
- das von dem Auswahlelement (10) ausgewählte Frequenzband;
- der eine bzw. die mehreren Schwellwertpegel des Schwellwert-Vergleichselement (60);
wobei die Vorrichtung ferner **dadurch gekennzeichnet ist, daß** die zumindest eine Steuereinheit (70) konfiguriert ist, den zumindest einen Überwachungsparameter in Reaktion auf die von der Kommunikationsschnittstelle (90) empfangenen Signale selektiv zu variieren.

2. Vorrichtung nach Anspruch 1, wobei diese eine Vielzahl von Antennenelementen (A1, A2, A3) umfaßt, deren Empfindlichkeit in verschiedene Richtungen orientiert ist.

3. Vorrichtung nach Anspruch 2, wobei diese mindestens drei Antennenelemente (A1, A2, A3) umfaßt, deren jeweilige Empfindlichkeitsrichtungen entlang eines Satzes von drei zueinander orthogonalen Achsen (X, Y, Z) orientiert sind.

4. Vorrichtung nach Anspruch 2, wobei die Antennenelemente der Vielzahl der Antennenelemente (A1, A2, A3) jeweils zu getrennten Empfangsketten (20, 30) zugeordnet sind, wobei die Vorrichtung ferner ein Multiplexerelement (40) umfaßt, um die von den getrennten Empfangsketten (20, 30) erzeugten Signale unter Verwendung eines allgemeinen Zeitmultiplexschemas zu handhaben.

5. Vorrichtung nach einem der vorangehenden Ansprüche, wobei die Kommunikationsschnittstelle als eine Schnittstelle zur Kommunikation mit einer mobilen Kommunikationsschnittstelle eingerichtet ist.

6. Vorrichtung nach Anspruch 1 oder 5, wobei die Kommunikationssschnittstelle (90) als serielle Schnittstelle arbeitet, vorzugsweise gemäß dem RS232-Standard.

7. Verteiltes Netz zur Überwachung elektromagnetischer Felder mit einer Vielzahl von Vorrichtungen gemäß einem der Ansprüche 1 bis 6.

## Revendications

1. Dispositif de surveillance de champs électromagnétiques, comprenant :
- au moins un élément d'antenne (A1, A2, A3) pour des mesures de champ électrique,
- une chaîne de réception (10, 20, 30) capable de générer au moins un signal qui est indicatif de l'intensité de champ électromagnétique mesurée par ledit au moins un élément d'antenne (A1, A2, A3),
- un élément comparateur de seuil (60) pour comparer ledit au moins un signal d'intensité de champ généré par ladite chaîne de réception (10, 20, 30) avec au moins un niveau de seuil associé,
ledit dispositif présentant également au moins l'une des caractéristiques suivantes :
- un élément sélecteur (10) agencé pour rendre le dispositif (1) sélectivement sensible à au moins deux bandes de fréquences de champ électromagnétique,
- ledit au moins un niveau de seuil dudit élément comparateur de seuil (60) étant sélectivement variable, ledit dispositif étant **caractérisé en ce qu'**il comprend en outre :
- une interface de communication (90) agencée de manière que des signaux puissent être transmis au dispositif (10), et
- au moins une unité de commande (70) configurée de manière à faire varier sélectivement au moins un paramètre de surveillance dans le groupe comprenant :
- la bande de fréquence sélectionnée par ledit élément sélecteur (10),
- ledit un ou plusieurs niveaux de seuil dudit élément comparateur de seuil (60) ;
- ledit dispositif étant en outre **caractérisé en ce que** ladite au moins une unité de commande (70) est configurée pour faire varier sélectivement ledit au moins un paramètre de surveillance en réponse aux signaux reçus à partir de ladite interface de communication (90).

2. Dispositif selon la revendication 1, **caractérisé en ce qu'**il comprend une pluralité d'éléments d'antenne (A1, A2, A3) dont la sensibilité est orientée dans différentes directions.

3. Dispositif selon la revendication 2, **caractérisé en ce qu'**il comprend au moins trois éléments d'antenne (A1, A2, A3) dont les directions respectives de sensibilité sont orientée suivant un ensemble de trois axes mutuellement orthogonaux (X, Y, Z).

4. Dispositif selon la revendication 2, **caractérisé en ce que** les éléments d'antenne dans ladite pluralité (A1, A2, A3) sont chacun associés à des chaînes de réception séparées (20, 30), le dispositif comprenant également un élément multiplexeur (40) pour gérer les signaux générés par lesdites chaînes de réception séparées (20, 30) en utilisant un schéma général de multiplexage par répartition dans le temps.

5. Dispositif selon l'une quelconque des revendications précédentes, **caractérisé en ce que** ladite interface de communication est configurée comme une interface pour la communication avec une interface de communication mobile.

6. Dispositif selon la revendication 1 ou la revendication 5, **caractérisé en ce que** ladite interface de communication (90) fonctionne comme une interface série, de préférence selon le standard RS232.

7. Réseau de surveillance de champ électromagnétique réparti comprenant une pluralité de dispositifs selon au moins l'une des revendications 1 à 6.
